(19)

Europäisches
Patentamt
European
Patent Office
Office européen
des brevets

(11) **EP 2 093 763 A1**

(12) **EUROPEAN PATENT APPLICATION**

(43) Date of publication:
**26.08.2009 Bulletin 2009/35**

(51) Int Cl.:
*G11B 20/10* (2006.01)

(21) Application number: **09305155.5**

(22) Date of filing: **18.02.2009**

<table>
<tr><td>

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **22.02.2008 EP 08101914**

(71) Applicant: **Thomson Licensing**
**92100 Boulogne-Billancourt (FR)**

</td><td>

(72) Inventors:
 • **Chen, Xiao-Ming**
  **30165, Hannover (DE)**
 • **Theis, Oliver**
  **30655, HANNOVER (DE)**

(74) Representative: **Thies, Stephan**
**Deutsche Thomson OHG**
**European Patent Operations**
**Karl-Wiechert-Allee 74**
**30625 Hannover (DE)**

</td></tr>
</table>

(54) **Method and apparatus for channel detection**

(57) The invention proposes a method for joint detection and channel decoding of binary data employing a trellis-based detector where the trellis describes RLL encoding, NRZI precoding, the influence of the channel, and PR equalization. In order to improve performance for the case of exchanging soft information with an outer soft-in soft-out (SISO) channel or ECC decoder under the presence of correlated noise, the trellis is extended to also comprise and model Noise Prediction.

Figure 1

EP 2 093 763 A1

**Description**

The present invention relates to channel encoding and decoding of binary data. This invention relates to joint bit detection and RLL decoding and noise prediction.

**Background**

For high-density optical storage systems, a so-called partial-response or PR maximum likelihood technique also known as PRML is employed for reliable bit detection. In PRML, a PR-equalizer is used to shape the overall channel impulse response to a desired PR target. Noise samples at the equalizer output are correlated, and the performance degradation due to correlated noise becomes significant with increased storage density. Therefore, to perform noise whitening, noise-predictive maximum likelihood detection was proposed in J.D. Coker et al, "Noise-predictive maximum likelihood (NPML) detection," IEEE Trans. Magnet., vol. 34, pp. 110-117, Jan. 1998 [1].

In order to effectively exchange soft information, also called reliability information, with an outer soft-in soft-out (SISO) channel or ECC decoder, joint bit detection and runlength limited (RLL) decoding has been investigated in F. Zhao et al, "Joint turbo channel detection and RLL decoding for (1, 7) coded partial response recording channels," IEEE ICC'03, pp. 2919-2923, 2003, and in M. Noda et al, "An 8-state DC-controllable run-length-limited code for the optical-storage channel," JJAP, vol. 44, No. 5B, pp. 3462-3466, 2005.

Accordingly, the concatenation of RLL encoder, non-return-to-zero inverted (NRZI) precoder, and PR channel is interpreted as an equivalent RLL-NRZI-PR channel, which can be represented by an RLL-NRZI-PR super-trellis. In this, "trellis" is an abbreviation known in the field, that stands for "tree-like structure". With this super-trellis, soft-in soft-out decoding algorithms such as BCJR, SOVA, or Max-Log-MAP can be applied to perform joint bit detection and RLL decoding.

**Summary of the Invention**

This invention starts by recognizing that previous super-trellis based approaches only considered ideal PR-channels. In the presence of correlated noise due to a PR equalizer, an RLL-NRZI-PR super-trellis based detector may not deliver satisfying bit error rate (BER) performance, without taking noise prediction into account. In addition, the quality of soft outputs from the RLL-NRZI-PR super-trellis based detector may be poor resulting in an ineffective soft-information exchange with an outer soft-in soft-out channel or ECC decoder such as a LDPC decoder or a turbo decoder for error correction.

Amongst others, the invention aims at how to perform joint bit detection and RLL decoding in the presence of colored noise at a reasonable complexity; and at how to effectively perform iterative soft-information exchange between the joint bit detector and RLL decoder with an outer soft-in soft-out decoder.

With other words, the concept of super-trellis detection is extended in this invention to additionally encompass noise predictive detection. In addition, to keep the detector complexity reasonably low, reduced-state variations of the super-trellis based detector are derived, based on the principle of delayed decision feedback sequence estimation.

In the presence of a noise predictor (NP), the concatenation of RLL encoder, NRZI precoder, PR channel, and noise predictor is here interpreted as an equivalent RLL-NRZI-PR-NP channel. Consequently, a super-trellis representing this RLL-NRZI-PR-NP channel is employed here to perform joint bit detection and RLL decoding.

Typically, the equivalent RLL-NRZI-PR-NP channel corresponds to an overall impulse response having many taps, i.e. of high degree. Because of this, reduced-state variations of the full-state RLL-NRZI-PR-NP super-trellis are derived and used here. With these reduced super-trellises, the part of the overall impulse response that is not covered within the trellis, is taken into account by tracing back surviving paths in the reduced-state super-trellis. In this, the memory length covered by the trellis is a design parameter K that trades off complexity and performance. In this context, appropriate soft-in soft-out algorithms are SOVA or Max-Log-MAP, because survivors exist there that can be traced back.

Using the RLL-NRZI-PR-NP super-trellis, or reduced-state variations thereof, allows that iterative soft-information exchange is carried out between the joint bit detector and RLL decoder and an outer soft-in soft-out decoder employing the turbo principle.

With other words: In this invention, instead of an impulse response h of a PR channel, an impulse response g which is a convolution of h with a noise prediction filter impulse response, is being modelled. This modelling is achieved in part by a trellis, and in part by backtracing survivor paths in the detector based on the trellis.

The invention relates to super-trellis based noise predictive detection for high density optical storage, where a runlength limited or RLL encoder, a non-return-to-zero inverted or NRZI precoder, a partial response or PR channel, and a noise predictor or NP together are interpreted as one equivalent RLL-NRZI-PR-NP channel.

For combining the RLL decoding trellis with the NRZI-PR channel, two approaches are shown which extend the RLL decoding trellis into an RLL-NRZI-PR-NP super-trellis by either looking backward or looking forward into the RLL decoding trellis. Investigating both of these is advantageous, because depending on the underlying RLL decoding trellis, either the first or the second approach may turn out to be less complex and thus preferable.

To maintain a reasonable detector complexity, reduced-state noise predictive detectors are derived. Three different $d$=1 RLL codes are compared with respect to the complexity of noise predictive detectors, showing the complexity advantage of our recently designed $d$=1, $k$=9 RLL code. Simulation results show that bit error rate performance gain obtained by the proposed detector increases as storage density increases.

The invention advantageously provides an improved bit error rate (BER) performance, compared to detectors without noise prediction, especially for high-density storage. It also provides an improved soft-output quality enabling a more effective soft information exchange between the super-trellis detector with an outer soft-in soft-out decoder.

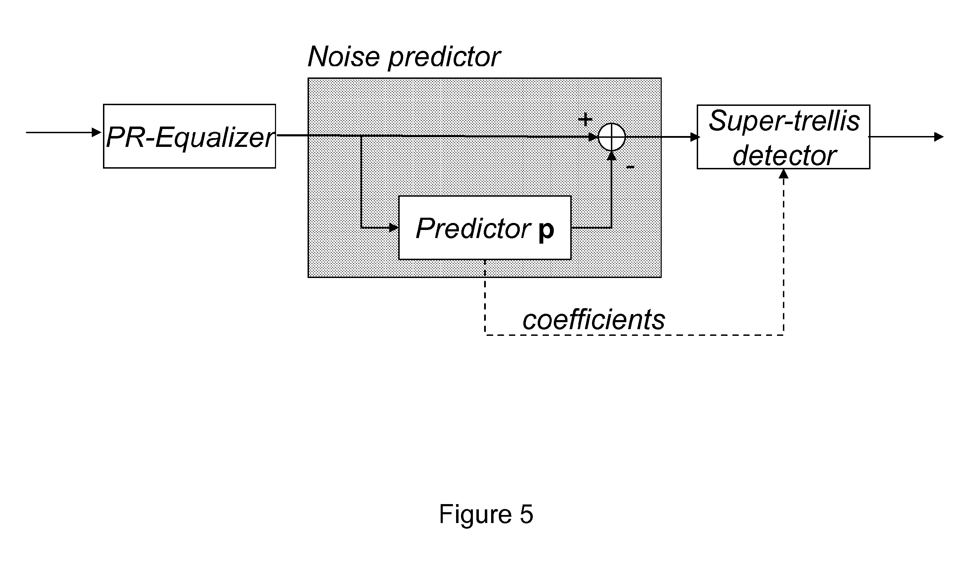

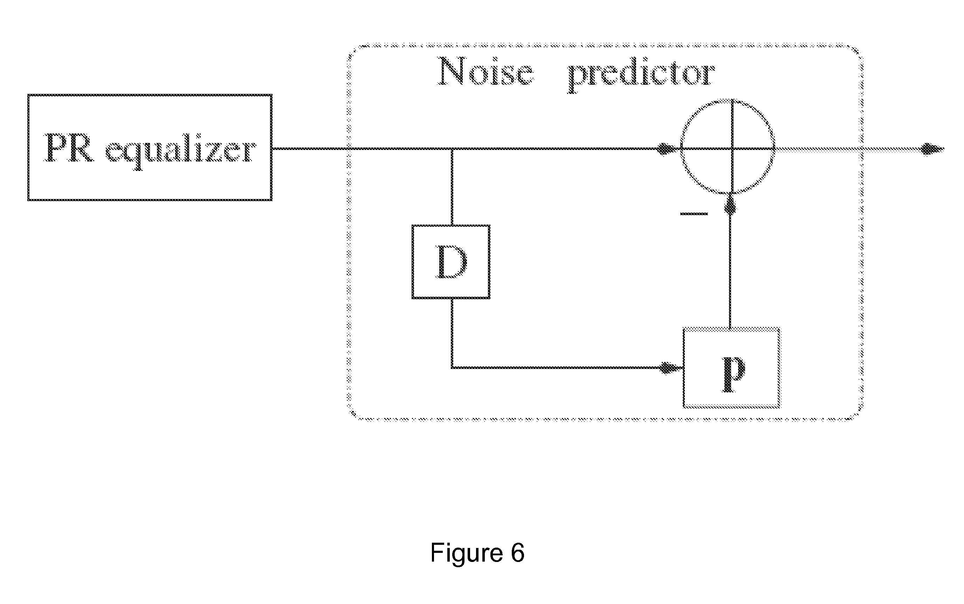

Figure 5 and Figure 6 depict Noise prediction (and compensation) for PR-channels with an impulse response of memory length L, meaning that an FIR filter equivalent would need a chain of L delay elements connected in series. An equivalent and sometimes preferable description of the impulse response is that of a coefficient vector h, which then has dimensionality L+1. As an example, an impulse response of [1,2,2,2,1] requires L=4 delay elements, the vector representation has dimensionality 5.

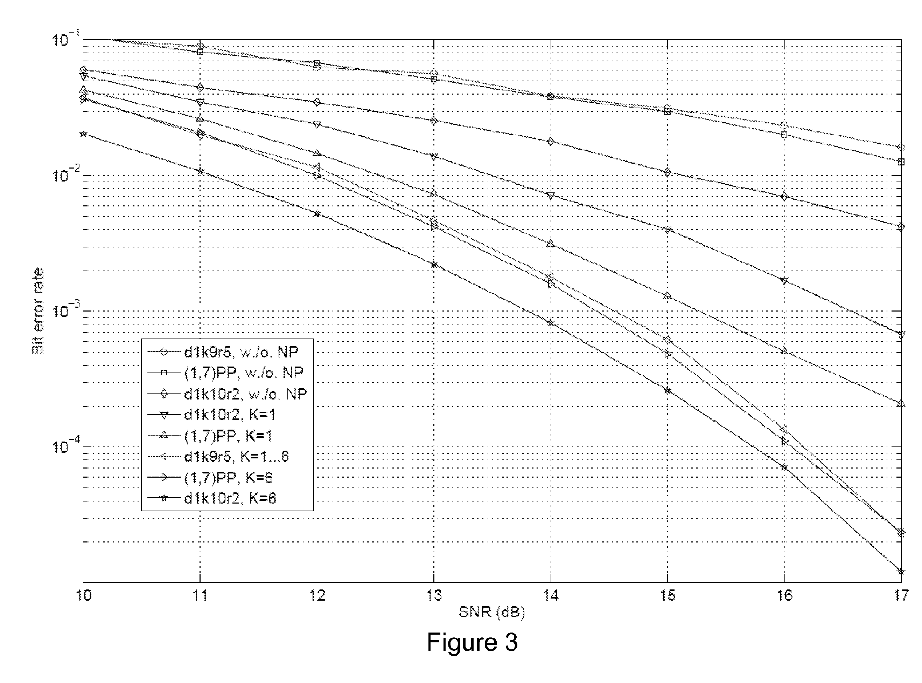

Figure 5 and Figure 6 are related to the structure shown in Fig. 3 of [1].

If noise prediction is applied, the effective length of the impulse response g of the overall system will generally be extended or increased, compared to that of the original impulse response h, according to

$$\texttt{g = conv(h, [1,-p])} \quad \texttt{of length Lp=L+M,}$$

where p denotes the predictor impulse response or predictor coefficient vector of length resp. dimensionality M.

Same as in [1], it is assumed here that noise predictor coefficients are computed based on the autocorrelation of the total distortion at the output of the PR-equalizer, see Appendix A and Eq. A.4 of [1].

Completely modelling the longer overall impulse response will need an increased number of trellis states and branches, so that, without further measures, detector complexity will rise significantly.

In [1] a traceback method for Viterbi detection is proposed for state reduction through ISI cancellation by delayed decision feedback. ISI stands for Inter-Symbol-Interference. Here, too, the design parameter K denotes the number of coefficients handled within the detector and directly governs trellis complexity, i.e. the number of states and branches. For example, K=L means that the PR-cannel ISI is completely reproduced or dealt with within the detector trellis. Any additional or residual ISI "induced" through noise prediction has to be cancelled through decision feedback by backtracing survivors in the trellis. For K<L, part of the channel ISI is also compensated through decision feedback. In cases of K>L, at least parts of the ISI "induced" through noise prediction is also compensated or dealt with within the detector states and branches.

This invention extends this approach to Super-trellis detectors.

Table 1 shows the number of trellis states and the number of branches needed for implementing three different channel decoders at different values of the design parameter K. The channel codes are:

- denoted as "(1,7)-PP", the (1,7)-PP code used on BluRay-Disc,
- denoted as "d1k10r2", the (d=1,k=10,r=2) RMTR RLL code presented in W. Coene et al, A new d=1, k=10 soft-decodable RLL code with r=2 RMTR constraint and a 2-to-3 PCWA mapping for DC-control, Optical Data Storage Topical Meeting, 2006, pp 168-170, and,
- denoted as "d1k9r5", a (1,9) RLL code with RMTR=5 we have designed with a remarkably low detector complexity.

Table entries are shown as number pairs "a/b", where "a" stands for the number of trellis states, and "b" stands for the number of branches.

In an embodiment of the invention, joint detection and channel decoding of binary data is achieved by steps of:

- receiving a sequence of channel output samples,
- applying a PR equalizer,
- applying a noise predictor, and
- applying a trellis-based detector which employs a single super-trellis which describes the combined effect of applying serially the signal processing steps of RLL encoding, NRZI precoding, channel, PR equalizer, and Noise Predictor.

PR channel targets include (1,1), (1,2,1), (1,2,2,1), (1,2,2,2,1), and (0.17, 0.5, 0.67, 0.5, 0.17).

**Brief Description of Figures**

Fig. 1          shows an information transmission model for optical storage systems that is used in this invention.

Table 1         shows, as a measure for complexity, the number of trellis states and branches, for RLL-NRZI-PR-NP super-trellises according to this invention, based on a (1,7)-PP code, a $d1k10r2$ code, and a $d1k9r5$ code, at different values of the design parameter K.

Fig. 2(a)       shows the Bit Error Rate BER over the SNR for the RLL-NRZI-PR-NP super-trellises according to this invention, based on the (1,7)-PP code, the $d1k10r2$ code, and the $d1k9r5$ code at different settings assuming a storage capacity of 25GB.

Fig. 2(b)       shows the Bit Error Rate BER over the SNR for the RLL-NRZI-PR-NP super-trellises according to this invention, based on the (1,7)-PP code, the $d1k10r2$ code, and the $d1k9r5$ code at different settings assuming a storage capacity of 30GB.

Fig. 3          shows the Bit Error Rate BER over the SNR for the RLL-NRZI-PR-NP super-trellises according to this invention, based on the (1,7)-PP code, the $d1k10r2$ code, and the $d1k9r5$ code at different settings assuming a storage capacity of 35GB.

Fig. 4(a)       shows the Bit Error Rate BER over the SNR for the RLL-NRZI-PR-NP super-trellis according to this invention based on the (1,7)-PP code at different values of the design parameter K, assuming a storage capacity of 35GB.

Fig. 4(b)       shows the Bit Error Rate BER over the SNR for the RLL-NRZI-PR-NP super-trellis according to this invention based on the $d1k9r5$ code at different values of the design parameter K, assuming a storage capacity of 35GB.

Fig. 4(c)       shows the Bit Error Rate BER over the SNR for the RLL-NRZI-PR-NP super-trellis according to this invention based on the $d1k10r2$ code at different values of the design parameter K, assuming a storage capacity of 35GB.

Fig. 5 and Fig. 6    show, in block diagram form, an arrangement, similar to Fig. 3 of [1], for Noise Prediction and compensation according to this invention, in a PRML detector.

**Detailed description**

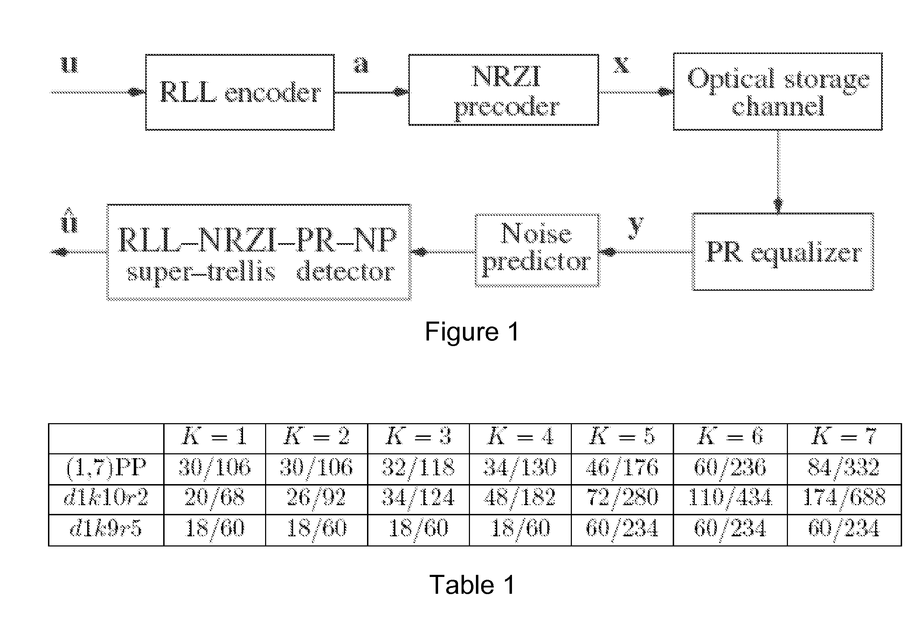

**Figure 1** shows the information transmission model for optical storage systems that is used here, where the Braat-Hopkins model is applied to optical storage channels using Blu-ray disc (BD) optics. Moreover, additive white Gaussian noise is present before the PR equalizer. The output signal of PR-equalizer is as follows:

$$y[k] = \sum_{l=0}^{L} h_l x[k-l] + e[k] \,,$$

where $\{\, h_l, 0 \leq l \leq L \,\}$ denote PR-target coefficients with $L$ as PR-channel memory length, $\{\, x[k] \,\}$ are channel bits after NRZI conversion, and $e[k]$ is colored noise. Moreover, $\{z[k]\}$ are noiseless PR channel outputs.

In the descibed embodiments, rate 2/3 RLL encoders are considered that have $\mathbf{u}_{2n}^{2n+1}$ as two data bits and $\mathbf{a}_{3n}^{3n+2}$ as three corresponding channel bits at index n. In this, the notation $\mathbf{v}_a^b$ denotes a sequence v from time index a to time index b. Given the phase reference x[3n-1], NRZI data symbols $\mathbf{x}_{3n}^{3n+2}$ can be obtained from $\mathbf{a}_{3n}^{3n+2}$ using

NRZI conversion. Consequently, $\mathbf{u}_{2n}^{2n+1}$ produces three noiseless PR channel outputs, $\mathbf{z}_{3n}^{3n+2}$, which depend on $\mathbf{x}_{3n-L}^{3n+2}$ due to the PR-channel memory.

RLL encoder, NRZI converter and PR-channel constitute an equivalent RLL-NRZI-PR channel, which has $\mathbf{u}_{2n}^{2n+1}$ as input and $\mathbf{z}_{3n}^{3n+2}$ as output. The RLL-NRZI-PR super-trellis can be constructed by expanding the RLL decoding trellis either in the backward or in the forward direction.

**A Looking backward approach to derive the extended trellis**

For a looking-backward approach [2,3,4], states in the super-trellis are defined as

$$s'[n] = (s[n], \mathbf{x}_{3n-L}^{3n-1}) \, , \qquad\qquad (1)$$

where $s[n]$ is a state in the RLL decoding trellis and state transitions thereof, denoted as $s[n] \rightarrow s[n+1]$, determine three NRZ data symbols $\mathbf{a}_{3n}^{3n+2}$. Consequently, state transitions $s'[n] \rightarrow s'[n+1]$ will provide NRZI data symbols $\mathbf{x}_{3n-L}^{3n+2}$, which are required to evaluate $\mathbf{z}_{3n}^{3n+2}$. In order to determine $\mathbf{x}_{3n-L}^{3n-1}$ in $s'[n]$, what we need is to obtain NRZ data symbols $\mathbf{a}_{3n-L+1}^{3n-1}$, given the phase reference $x[3n-L]$. This can be accomplished if we trace back the RLL decoding trellis from $s[n]$ by $N_b$ steps. Since each tracing back step provides three past NRZ data symbols, the following condition should be fulfilled:

$$3(n - N_b) \le 3n - L + 1 \Rightarrow N_b = \left\lceil \frac{L-1}{3} \right\rceil , \qquad\qquad (2)$$

where $\lceil a \rceil$ denotes the smallest integer not less than $a$. Let $L_b = 3N_b$, then $N_b$-step tracing back provides an NRZ data set $\mathbf{A}_b(s[n]) = \{ \mathbf{a}_{3n-L_b}^{3n-1} \mid s[n] \}$, which includes all possible NRZ data sequences $\mathbf{a}_{3n-L_b}^{3n-1}$ that merge into a specific state $s[n]$. For NRZ to NRZI conversion, there are two possible phase references $x[3n-L_b-1]=+1$ or $x[3n-L_b-1]=-1$. Therefore, we obtain the NRZI data set $\mathbf{X}_b(s[n]) = \{ \mathbf{x}_{3n-L_b-1}^{3n-1} \mid s[n] \}$ with $|\mathbf{X}_b(s[n])|=2|\mathbf{A}_b(s[n])|$, where $|\mathbf{A}|$ denotes the cardinality of the set $\mathbf{A}$. Based on $\mathbf{X}_b(s[n])$, the set of data symbols $\mathbf{x}_{3n-L}^{3n-1}$ can easily be found for a specific $s[n]$, which is used to define $s'[n]$ in eq. (1).

**A Looking forward approach to derive the extended trellis**

Alternatively, we may look forward $N_f$ steps diverging from $s[n]$.

Three noiseless PR-channel outputs $\mathbf{z}_{3(n+L_f)}^{3(n+L_f)+2}$ may be employed for the evaluation of branch metrics, which depend on NRZI data symbols $\mathbf{x}_{3(n+L_f)-L}^{3(n+L_f)+2}$. Note that for $N_f=0$, we get $\mathbf{z}_{3n}^{3n+2}$ as before. Since state transitions in the RLL decoding trellis $s[n] \rightarrow s[n+1]$ deliver $\mathbf{a}_{3n}^{3n+2}$ and we take the phase reference $x[3n-1]$ into account, the following condition has to be fulfilled:

$$3(n + N_f) - L \geq 3n - 1 \Rightarrow N_f = \left\lceil \frac{L-1}{3} \right\rceil. \qquad (3)$$

Therefore, states in a looking-forward super-trellis are defined as

$$s'[n] = (s[n], \mathbf{x}_{3(n+N_f)-L}^{3(n+N_f)-1}), \qquad (4)$$

where state transitions $s'[n] \rightarrow s'[n+1]$ provide NRZI data symbols $\mathbf{x}_{3(n+L_f)-L}^{3(n+L_f)+2}$. The determination of $\mathbf{x}_{3(n+L_f)-L}^{3(n+L_f)-1}$ for $s'$ [n] in Eq. (4) can be accomplished similarly as the procedure presented for the looking-backward approach.

**Super-Trellis Based Noise Predictive Detection**

In the presence of a noise predictor NP, the equivalent channel up to the bit detector is composed of an RLL encoder, an NRZI precoder, a PR channel, and a Noise Predictor, all of which is referred to as an "RLL-NRZI-PR-NP channel" in the sequel, as also shown in Figure 1.

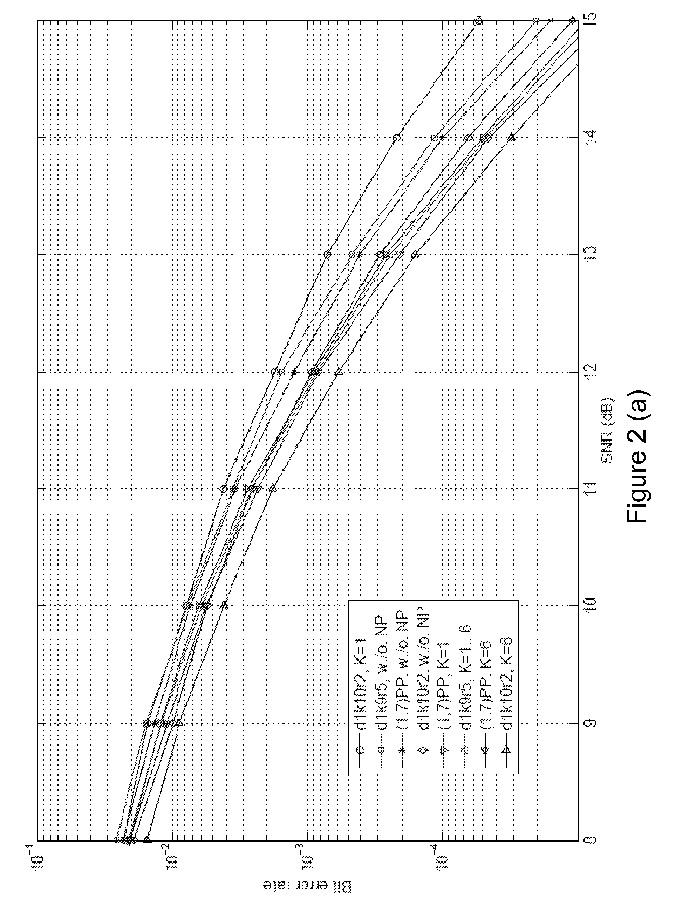

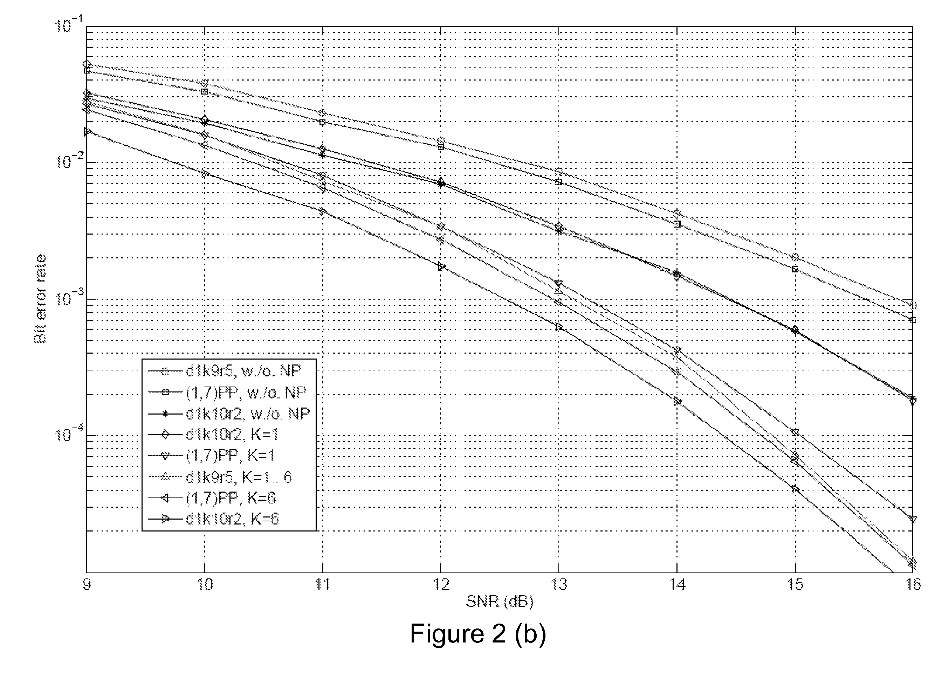

Let $\mathbf{p} = [p_1, \ldots, p_M]$ denote a noise prediction vector, the PR-NP channel shown in Fig. 2 can be described as

$$\mathbf{g} = conv(\mathbf{h}, [1, -\mathbf{p})], $$

where conv( ) stands for discrete-time convolution and $\mathbf{h}$ represents the PR target. Moreover, the channel memory length of the PR-NP channel is $L_p = L + M$. Accordingly, states in the RLL-NRZI-PR-NP super-trellis are defined as

$(s[n], \mathbf{x}_{3n-L_p}^{3n-1})$ if looking backward the RLL decoding trellis, or as $(s[n], \mathbf{x}_{3(n+L_f)-L_p}^{3(n+L_f)-1})$ for a looking-forward approach.

Instead of employing an explicit noise predictor in front of the detector designed for RLL-NRZI-PR-NP channel, we may also employ detectors designed for RLL-NRZI-PR channel with embedded noise prediction. Both approaches are theoretically equivalent, but they are different from the viewpoint of implementation. As shown in ref. 1, the approach with an explicit noise predictor provides implementation advantages.

To trade off the computational complexity and performance of an RLL-NRZI-PR-NP super-trellis based detector, a reduced-state super-trellis can be derived by a design parameter $K \in \lfloor 1, L_p \rfloor$,

where states in the reduced-state super-trellis are defined either as $(s[n], \mathbf{x}_{3n-K}^{3n-1})$ or as $(s[n], \mathbf{x}_{3(n+L_f)-K}^{3(n+L_f)-1})$. Note that a phase reference is always required for NRZ-to-NRZI conversion, therefore, $K \geq 1$. State transitions in the reduced-state super-trellis only provide $K+3$ NRZI data symbols. In order to obtain the other $L_p - K$ data symbols, delayed decision feedback sequence estimation [6] can be applied for super-trellis, where surviving paths for individual states in the reduced-state super-trellis are traced back by $N_p$ steps. Since each step during tracing back provides three past decisions on NRZI symbols, we have $N_f = \left\lceil \frac{L_p - K}{3} \right\rceil$. For SISO reduced-state detectors, a SOVA or Max-Log-MAP algorithm should be employed, since there are survivors for both algorithms enabling a trace-back. In contrast, no survivor is available using a BCJR or a Log-MAP algorithm.

We considered the (1,7)-PP code adopted for BD standards, a (1,10) code with a repeated minimum transition runlength (RMTR) constraint of 2 (shortly termed as $d1k10r2$ code) [7], and a (1,9) code [8] with an RMTR constraint of 5 that we have designed (denoted as $d1k9r5$ code) with a decoding state transition table given in Table 2. The decoding state transition table for the (1,7)-PP code was included in [4], and for the $d1k10r2$ code the RLL decoding trellis can be derived from its encoding tables [7]. It was verified that the looking-backward approach provides a less complex super-trellis for both the (1,7)-PP code and the $d1k10r2$ code, while for the $d1k9r5$ code the looking-forward approach is preferable. Table 1 compares the RLL-NRZI-PR-NP super-trellis complexity for these three codes with respect to the number of states/branches. For $K \leq 4$, the super-trellis employing the $d1k9r5$ code has a significantly lower complexity, while for $K \geq 3$ the super-trellis employing the $d1k10r2$ code has a higher complexity. In addition, the super-trellis employing the $d1k9r5$ code has the same complexity for $K \leq 4$ and for $K \in [5,7]$, since each state in the RLL decoding trellis has three unique upcoming RLL bits, refer to the following Table 2.

**Table 2:** RLL decoding trellis state transition table for the $d1k9r5$ code.

| Previous state $s[n]$ | Current data bits $\mathbf{u}_{2n}^{2n+1}$ | Current RLL bits $\mathbf{a}_{3n}^{3n+2}$ | Current state $s[n+1]$ |
|---|---|---|---|
| S0 | 01 | 000 | S1 |
| S0 | 01 | 000 | S2 |
| S0 | 01 | 000 | S3 |
| S0 | 01 | 000 | S5 |
| S0 | 11 | 000 | S8 |
| S1 | 10 | 001 | S1 |
| S1 | 10 | 001 | S2 |
| S1 | 10 | 001 | S6 |
| S2 | 10 | 010 | S0 |
| S2 | 11 | 010 | S1 |
| S2 | 11 | 010 | S2 |
| S2 | 11 | 010 | S3 |
| S2 | 11 | 010 | S5 |
| S3 | 00 | 100 | S0 |
| S3 | 01 | 100 | S1 |
| S3 | 01 | 100 | S2 |
| S3 | 01 | 100 | S3 |
| S3 | 01 | 100 | S5 |
| S4 | 11 | 000 | S3 |
| S4 | 11 | 000 | S5 |
| S5 | 00 | 101 | S1 |
| S5 | 00 | 101 | S2 |
| S5 | 00 | 101 | S6 |
| S6 | 00 | 000 | S1 |
| S6 | 00 | 000 | S2 |
| S6 | 00 | 000 | S3 |
| S6 | 00 | 000 | S5 |
| S6 | 11 | 000 | S7 |
| S7 | 00 | 000 | S4 |
| S8 | 00 | 000 | S2 |

### Simulation Results

A linear equalizer based on the minimum mean square error (MMSE) principle with 19 coefficients is employed as PR equalizer, where the PR target is selected as $\mathbf{h}=[1, 2, 2, 1]$. For MMSE prediction [1], the prediction order is chosen as $M=20$ resulting in $L_p=23$, and joint bit detection and RLL decoding is carried out using the Max-Log-MAP algorithm, which is appropriately modified for super-trellis based detectors. For simulations, signal-to-noise ratio (SNR) is defined as the reciprocal of the additive white Gaussian noise variance.

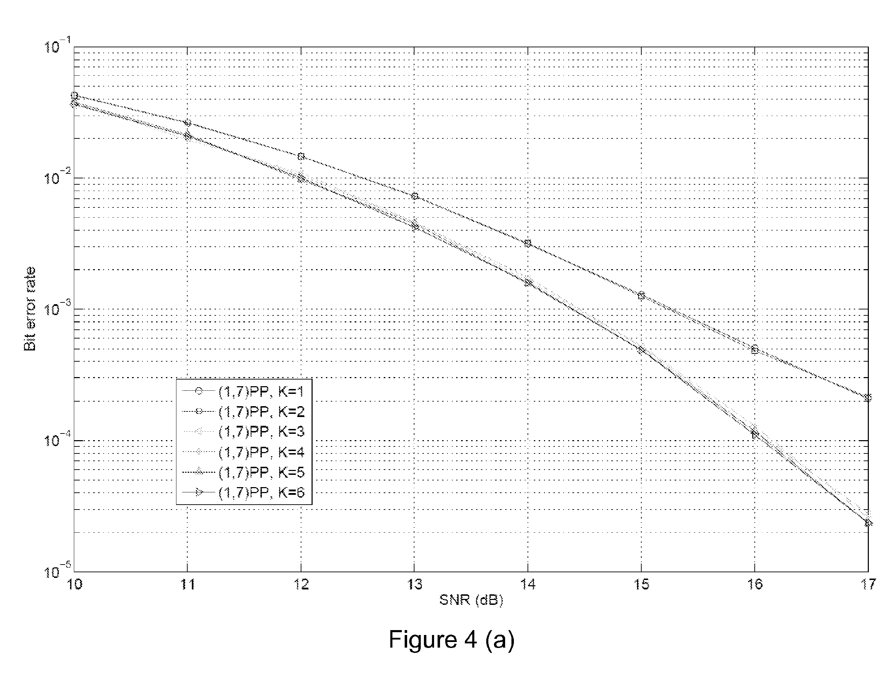

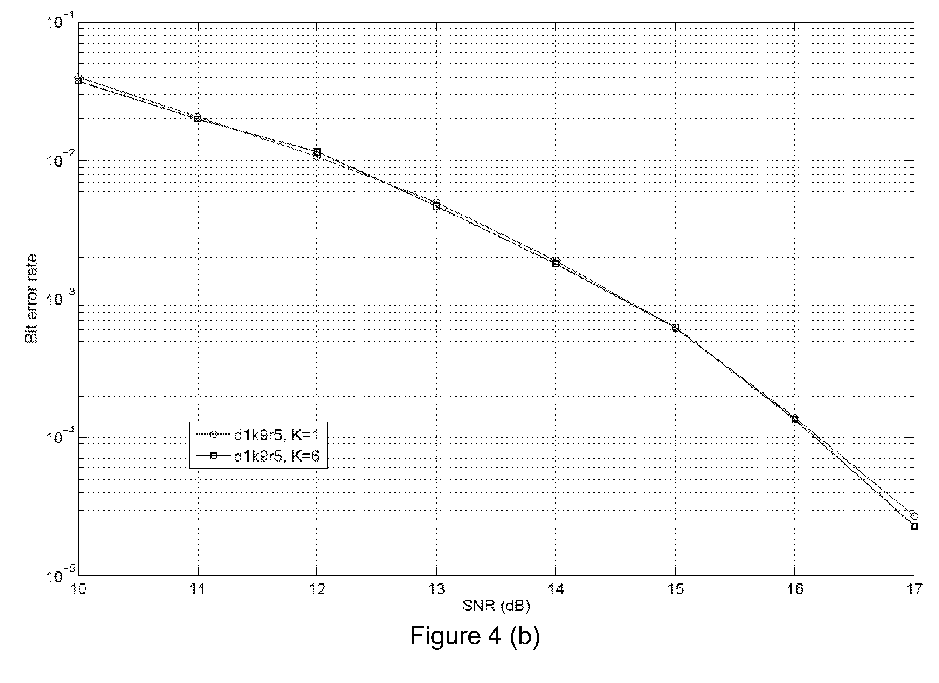

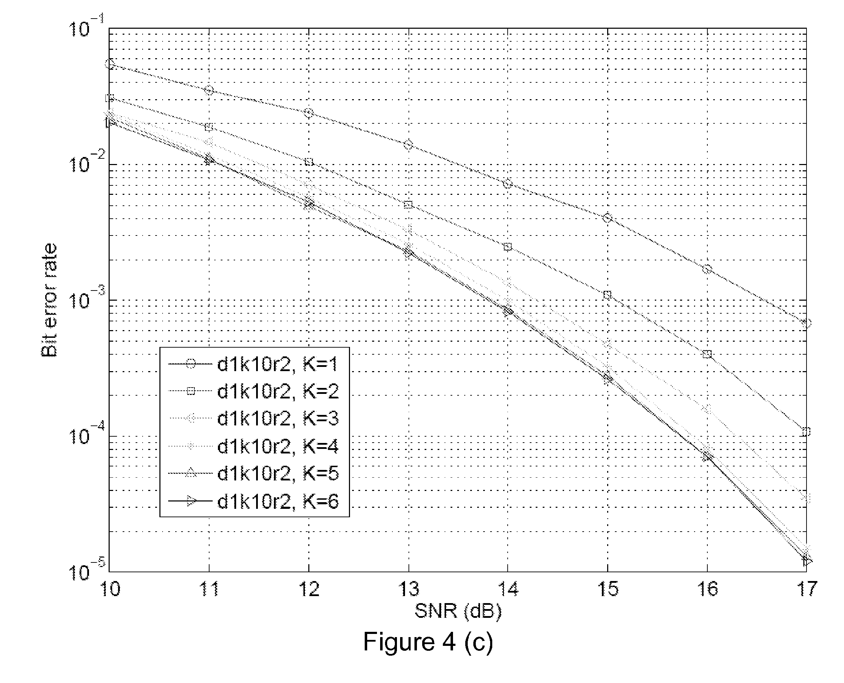

BER performance is compared between RLL-NRZI-PR-NP super-trellis based detectors and the known RLL-NRZI-PR super-trellis based detector, where the complexity of the latter is similar to the former detectors with $K=3$. As shown in Figs. 3 and 4, the performance gap between RLL-NRZI-PR-NP super-trellis based detectors and the RLL-NRZI-PR super-trellis based detector increases as the storage density increases from 25 GB to 35 GB. Moreover, the gap between a detector with a small $K$ and a detector with a large $K$ also increases with the increased storage density for the (1,7)-PP code and for the $d1k10r2$ code. For the $d1k9r5$ code, there is no performance difference for detectors with $K \in [1,6]$. Therefore, only the BER performance for $K=6$ is shown in Figs. 3 and 4 for the $d1k9r5$ code.

Under the 35 GB capacity, as shown in Fig. 5, for the (1,7)-PP code no performance improvement is visible by increasing the detector complexity if $K \geq 3$. For the $d1k10r2$ code, the performance improves gradually with increased complexity, while no further improvement was observed for $K \geq 4$. Although a similar performance has been obtained for the (1,7)-PP code with $K=3$ and the $d1k9r5$ code with $K \leq 4$, the detector complexity of the $d1k9r5$ code is only approximately one half of that of the (1,7)-PP code. In the case of the $d1k10r2$ code, the detector with $K=4$ provides a slight performance improvement, while the detector complexity is significantly higher, refer to Table 1.

Incorporating noise prediction, RLL-NRZI-PR-NP super-trellis based bit detectors were investigated. For the super-trellis construction, we showed that both looking-forward and looking-backward the RLL decoding trellis are possible, where one of these two approaches is advantageous with respect to super-trellis complexity. With increased storage density, noise prediction based detectors provide increased performance gain. In the presence of an outer SISO channel decoder such as a turbo decoder or a LDPC decoder, the turbo principle, i.e., iterative exchange of extrinsic information between the inner SISO RLL-NRZI-PR-NP detector and the outer SISO channel decoder, can be applied straightforwardly. Systems employing the $d1k9r5$ code with a lower detector complexity have a similar performance as systems employing the (1,7)-PP code, while systems employing the $d1k10r2$ code have a better performance at the expense of a higher detector complexity.

## REFERENCES

[1] J.D. Coker, E. Eleftheriou, R.L. Galbraith, and W. Hirt: IEEE Trans. Magn. 34 (1998) 110.

[2] E. Yamada, T. Iwaki and T. Yamaguchi: Jpn. J. Appl. Phys. 41 (2002) 1753.

[3] F. Zhao, G. Mathew, and B. Farhang-Boroujeny: Proc. IEEE ICC, 2003, p. 2919.

[4] T. Miyauchi, Y. Shinohara, Y. Iida, T. Watanabe, Y. Urakawa, H. Yamagishi, and M. Noda: Jpn. J. Appl. Phys. 44 (2005) 3471.

[5] K. Cai, G. Mathew, J. W. M. Bergmans and Z. Qin: Proc. IEEE ICCE, 2003, p. 324.

[6] W. Coene, A. Hekstra, B. Yin, H. Yamagishi, M. Noda, A. Nakaoki, and T ~Horigome: Proc. SPIE 6282 (2006) 62820X..

[7] O. Theis, X.-M.Chen, D. Hepper, and G. Pilard: Tech. Dig. ISOM/ODS, 2008, p. 425.

## Claims

1. Method for joint detection and channel decoding of binary data, applying a trellis-based detector in which a single super-trellis describes the signal processing of an RLL encoding stage, an NRZI precoding stage, the channel, a PR equalizer stage, and a Noise predictor stage.

2. A method according to claim 1, where the trellis-based detector uses, for complexity reasons, a trellis of reduced number of states, together with a traceback of surviving paths according to a delayed decision feedback approach.

3. A method according to one of the previous claims, wherein the RLL encoding has a lower runlength of 1 and an upper runlength of 9.

4. A method according to one of the previous claims, wherein the PR equalizer filters the channel output samples such that the filtered samples achieve a target impulse response of (1,2,2,2,1).

5. A method according to one of the previous claims, wherein the Noise predictor performs a convolution of the output of the PR equalizer with an FIR prediction filter and subtracts the result of the convolution from the output of the PR equalizer.

6. A SISO trellis-based detector for joint channel detection and RLL decoding, whose trellis comprises the combination of a PR channel trellis and an RLL code trellis, **characterized in that** the trellis also incorporates a noise prediction filter.

**7.** A method for joint data detection and channel or ECC decoding, wherein a data detection step that uses a trellis-based detector, and a channel or ECC decoding step that uses a SISO channel or ECC decoder are iteratively repeated according to the turbo principle, soft information is exchanged between the detection step and the decoding step in both directions, and the trellis of the data detection step incorporates a noise prediction filter.

**8.** A method according to claim 7, wherein the SISO channel or ECC decoder is a message passing decoder.

Figure 1

| | $K = 1$ | $K = 2$ | $K = 3$ | $K = 4$ | $K = 5$ | $K = 6$ | $K = 7$ |
|---|---|---|---|---|---|---|---|
| $(1,7)$PP | 30/106 | 30/106 | 32/118 | 34/130 | 46/176 | 60/236 | 84/332 |
| $d1k10r2$ | 20/68 | 26/92 | 34/124 | 48/182 | 72/280 | 110/434 | 174/688 |
| $d1k9r5$ | 18/60 | 18/60 | 18/60 | 18/60 | 60/234 | 60/234 | 60/234 |

Table 1

Figure 2 (a)

Figure 2 (b)

Figure 3

EP 2 093 763 A1

Figure 4 (a)

Figure 4 (b)

EP 2 093 763 A1

Figure 4 (c)

EP 2 093 763 A1

Figure 5

Figure 6

Europäisches
Patentamt

European
Patent Office

Office européen
des brevets

## PARTIAL EUROPEAN SEARCH REPORT

which under Rule 63 of the European Patent Convention
shall be considered, for the purposes of subsequent
proceedings, as the European search report

Application Number

EP 09 30 5155

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,A | COKER J D ET AL: "Noise-predictive maximum likelihood (NPML) detection" IEEE TRANSACTIONS ON MAGNETICS, IEEE SERVICE CENTER, NEW YORK, NY, US, vol. 34, no. 1, January 1998 (1998-01), pages 110-117, XP002125790 ISSN: 0018-9464 * the whole document * | 1-8 | INV. G11B20/10 |
| D,A | M. NODA AND H. YAMAGASHI: "An 8-State DC-Controllable Run-Length-Limited Code for the Optical-Storgae Channel" JAPANESE JOURNAL OF APPLIED PHYSICS, [Online] vol. 44, no. 5B, 24 May 2005 (2005-05-24), pages 3462-3466, XP002475474 Retrieved from the Internet: URL:http://jjap.ipap.jp/link?JJAP/44/3462> [retrieved on 2008-04-07] * the whole document * -/-- | 1-8 | |

TECHNICAL FIELDS
SEARCHED     (IPC)

G11B

## INCOMPLETE SEARCH

The Search Division considers that the present application, or one or more of its claims, does/do
not comply with the EPC to such an extent that a meaningful search into the state of the art cannot
be carried out, or can only be carried out partially, for these claims.

Claims searched completely :

Claims searched incompletely :

Claims not searched :

Reason for the limitation of the search:

see sheet C

| Place of search | Date of completion of the search | Examiner |
|---|---|---|
| The Hague | 25 March 2009 | Van Staveren, Martin |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04E07)

Europäisches
Patentamt

European
Patent Office

Office européen
des brevets

**PARTIAL EUROPEAN SEARCH REPORT**

Application Number

EP 09 30 5155

| | DOCUMENTS CONSIDERED TO BE RELEVANT | | CLASSIFICATION OF THE APPLICATION (IPC) |
|---|---|---|---|
| Category | Citation of document with indication, where appropriate, of relevant passages | Relevant to claim | |
| D,A | ZHAO FANG ET AL: "Joint turbo channel detection and rll decoding for (1, 7) coded partial response recording channels" ICC 2003. 2003 IEEE INTERNATIONAL CONFERENCE ON COMMUNICATIONS. ANCHORAGE, AK, MAY 11 - 15, 2003, IEEE INTERNATIONAL CONFERENCE ON COMMUNICATIONS, NEW YORK, NY : IEEE, US, vol. VOL. 1 OF 5, 11 May 2003 (2003-05-11), pages 2919-2923, XP010642979 ISBN: 0-7803-7802-4 * the whole document * | 1-8 | |
| D,A | COENE W ET AL: "A New d=1, k=10 Soft-Decodable RLL Code with r=2 MTR-Constraint and a 2-to-3 PCWA Mapping for DC-Control" OPTICAL DATA STORAGE TOPICAL MEETING, 2006 MONTREAL, QUEBEC, CANADA 23-26 APRIL 2006, PISCATAWAY, NJ, USA,IEEE, 23 April 2006 (2006-04-23), pages 168-170, XP010916954 ISBN: 0-7803-9494-1 * the whole document * | 1-8 | **TECHNICAL FIELDS SEARCHED (IPC)** |
| A | CHEVILLAT P R ET AL: "NOISE-PREDICTIVE PARTIAL-RESPONSE EQUALIZERS AND APPLICATIONS" DISCOVERING A NEW WORLD OF COMMUNICATIONS. CHICAGO, JUNE 14 - 18, 1992, PROCEEDINGS OF THE INTERNATIONAL CONFERENCE ON COMMUNICATIONS, NEW YORK, IEEE, US, vol. VOL. 2, 14 June 1992 (1992-06-14), pages 942-947, XP000326811 ISBN: 0-7803-0599-X * the whole document * | 1-8 | |

-/--

EPO FORM 1503 03.82 (P04C10)

Europäisches
Patentamt

European
Patent Office

Office européen
des brevets

**PARTIAL EUROPEAN SEARCH REPORT**

Application Number

EP 09 30 5155

| | DOCUMENTS CONSIDERED TO BE RELEVANT | | CLASSIFICATION OF THE APPLICATION (IPC) |
|---|---|---|---|
| Category | Citation of document with indication, where appropriate, of relevant passages | Relevant to claim | |
| A | WO 00/13179 A (IBM [US]) 9 March 2000 (2000-03-09) * the whole document * ----- | 1-8 | |
| | | | **TECHNICAL FIELDS SEARCHED** (IPC) |

EPO FORM 1503 03.82 (P04C10)

Europäisches
Patentamt
European
Patent Office
Office européen
des brevets

**INCOMPLETE SEARCH
SHEET C**

Application Number

EP 09 30 5155

Claim(s) searched incompletely:
        1-8

Claim(s) not searched:
            -

Reason for the limitation of the search:

1. D1 = Coker et al., reference [1] in this application.


2.      This application claims priority from European application
08101914, which has been abandoned.

The present application states in page 5, lines 19-22: "Same as in [1],
it is assumed here that noise predictor coefficients are computed based
on the autocorrelation of the total distortion at the output of the
PR-equalizer, see Appendix A and Eq. A.4 of [1]", where [1] is D1. This
statement is not present in the priority application 08101914, and
therefore the priority claim is invalid.

Furthermore, Appendix A of D1 relates to the estimation of the distortion
of only the PR equalizer, as is clearly discussed in D1, section II. In
D1 this is possible, as the PR equalizer is separate from the Viterbi
decoder.

Claim 1 of this application defines a

Method for joint detection and channel decoding of binary data, applying
a trellis-based detector in which a single super-trellis describes the
signal processing of an RLL encoding stage, an NRZI precoding stage, the
channel, a PR equalizer stage, and a Noise predictor stage.

Claim 6 defines

A SISO trellis-based detector for joint channel detection and RLL
decoding, whose trellis comprises a combination of a PR channel trellis
and an RLL code ztrellis, characterized in that the trellis also
incorporates a noise prediction filter.

Claim 7 defines

A method for joint data detection and channel or ECC decoding, wherein a
data detection step that uses a trellis-based detector, and a channel or
ECC decoding step that uses a SISO channel or ECC decoding step that uses
a SISO channel or ECC decoder that are iteratively repeated according to
the turbo principle, soft information is exchanged between the detection
step and the decoding step in both directions, and the trellis of the
data detection step incorporates a noise prediction filter.

The present application does not disclose how the results of D1, Appendix
A should be used in the detector of claim 6 or in the methods of claims 1
and 7. On page 5 of this application, it is stated that g is the impulse
response of the overall system. There is no disclosure of how the PR

Europäisches
Patentamt

European
Patent Office

Office européen
des brevets

**INCOMPLETE SEARCH**
**SHEET C**

equalizer tap optimization of D1, Appendix A would be used in the claimed invention. The application does not provide any other disclosure of how the predictor impulse response of page 5, lines 9-17 should be determined.

The application is therefore contrary to Art. 83 EPC, and no opinion about novelty or inventive step can be given.

## ANNEX TO THE EUROPEAN SEARCH REPORT
## ON EUROPEAN PATENT APPLICATION NO.

EP 09 30 5155

This annex lists the patent family members relating to the patent documents cited in the above-mentioned European search report.
The members are as contained in the European Patent Office EDP file on
The European Patent Office is in no way liable for these particulars which are merely given for the purpose of information.

25-03-2009

| Patent document cited in search report | | Publication date | Patent family member(s) | | Publication date |
|---|---|---|---|---|---|
| WO 0013179 | A | 09-03-2000 | CN | 1315039 A | 26-09-2001 |
| | | | DE | 69929212 T2 | 27-07-2006 |
| | | | EP | 1110216 A1 | 27-06-2001 |
| | | | HU | 0103435 A2 | 28-01-2002 |
| | | | JP | 3483854 B2 | 06-01-2004 |
| | | | JP | 2002524812 T | 06-08-2002 |
| | | | TW | 448424 B | 01-08-2001 |
| | | | US | 6158027 A | 05-12-2000 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **J.D. Coker et al.** Noise-predictive maximum likelihood (NPML) detection. *IEEE Trans. Magnet.,* January 1998, vol. 34, 110-117
- **F. Zhao et al.** Joint turbo channel detection and RLL decoding for (1, 7) coded partial response recording channels. *IEEE ICC'03,* 2003, 2919-2923
- **M. Noda et al.** An 8-state DC-controllable run-length-limited code for the optical-storage channel. *JJAP,* 2005, vol. 44 (5B), 3462-3466
- **W. Coene et al.** A new d=1, k=10 soft-decodable RLL code with r=2 RMTR constraint and a 2-to-3 PCWA mapping for DC-control. *Optical Data Storage Topical Meeting,* 2006, 168-170
- **J.D. Coker ; E. Eleftheriou ; R.L. Galbraith ; W. Hirt.** *IEEE Trans. Magn.,* 1998, vol. 34, 110
- **E. Yamada ; T. Iwaki ; T. Yamaguchi.** *Jpn. J. Appl. Phys.,* 2002, vol. 41, 1753
- **F. Zhao ; G. Mathew ; B. Farhang-Boroujeny.** *Proc. IEEE ICC,* 2003, 2919
- **T. Miyauchi ; Y. Shinohara ; Y. Iida ; T. Watanabe ; Y. Urakawa ; H. Yamagishi ; M. Noda.** *Jpn. J. Appl. Phys.,* 2005, vol. 44, 3471
- **K. Cai ; G. Mathew ; J. W. M. Bergmans ; Z. Qin.** *Proc. IEEE ICCE,* 2003, 324
- **W. Coene ; A. Hekstra ; B. Yin ; H. Yamagishi ; M. Noda ; A. Nakaoki ; T ~Horigome.** *Proc. SPIE,* 2006, vol. 6282, 62820X
- **O. Theis ; X.-M.Chen ; D. Hepper ; G. Pilard.** *Tech. Dig. ISOM/ODS,* 2008, 425